# EUROPEAN PATENT APPLICATION

(11) **EP 4 088 828 A1**
(43) Date of publication of application: **16.11.2022**
(21) Application number: 22156591.4
(22) Date of filing: 14.02.2022
(51) Int. Cl.: B05D 1/00, C23C 16/455, C23C 16/56, H05K 3/34, B23K 1/20, H01M 4/62, H01L 23/00

(54) **TEMPORARY PASSIVATION LAYER ON A SUBSTRATE**

(30) Priority: 09.05.2021 US 202117315342
(71) Applicant: SPTS Technologies Limited, Newport Gwent NP18 2TA (GB)
(72) Inventor: Grimes, Michael, Newport (US); Lin, Yuyuan, Newport (US)
(74) Representative: Wynne-Jones IP Limited

(57) **Abstract**

A substrate includes a metal component on a surface. A polymeric layer is deposited on the surface using molecular layer deposition. The polymeric layer includes a metalcone and has a thickness from 1 nm to 20 nm. The polymeric layer is stable at room temperature, but will undergo a structural change at high temperatures. The polymeric layer can be annealed to cause a structural change, which can occur during soldering.

## Description

### FIELD OF THE DISCLOSURE

This disclosure relates to semiconductor processing.

### BACKGROUND OF THE DISCLOSURE

Many metals are susceptible to oxidation when exposed to or stored in atmospheric conditions. Oxidation of metals causes a metal oxide to form on the surface of the metal. The formation of surface metal oxides can have detrimental effects on the chemical, mechanical, optical, and electrical properties of the metal. For these reasons, metal oxides are typically removed from metallic surfaces prior to forming an electrical connection. However, metal oxides may grow to beyond nanometer levels, and can be difficult and time-consuming to remove. It is therefore desirable to prevent the formation of surface metal oxides.

One approach for preventing the formation of surface metal oxides includes forming a passivation layer. A "passivation layer" is a protective film, layer, or coating deposited on the surface of a substrate to suppress or inhibit chemical reactions, such as oxidation reactions, occurring at that surface. A passivation layer typically acts as an oxidation barrier layer, which inhibits oxidation of the underlying surface. In the case of a metallic surface, such as a copper surface, a passivation layer inhibits the oxidation of the metallic surface, and thereby prevents corrosion.

Some known passivation layers are permanent. For example, it is known to deposit alumina directly onto a metallic surface to suppress oxidation. However, removal of such a permanent passivation layer typically requires aggressive chemical etching, mechanical polishing, plasma treatment, or other processes which could damage other components of the substrate.

When forming electrical connections, a layer of organic solderability preservative (OSP) can be deposited on a surface of a metal, such as copper, prior to soldering. The OSP layer inhibits oxidation of the metallic surface prior to soldering and acts as a passivation layer. The OSP is an organic coating that requires a thickness ranging from approximately 100 nm to several microns to be effective.

The OSP passivation layer must be of a minimum thickness (usually several 100 nm) to sufficiently suppress oxidation of the underlying metallic surface. Depositing OSP layers typically results in the OSP layer having a non-uniform thickness across the substrate surface. Thick and/or non-uniform OSP layers may be difficult to fully remove and OSP residues may contaminate the substrate during subsequent processing steps. OSP materials also suffer from a short shelf life and often require relatively aggressive flux application to remove any residues from the OSP during bonding and assembly, which can lead to other problems.

Gold and other metallic films also have been used to prevent oxidation. However, gold and other metallic films can cause interlayer diffusion, which results in defects. If gold is used as the barrier, a thick (typically microns) metallic diffusion barrier layer (e.g., nickel, palladium, etc.) is usually applied before the gold layer to prevent inter-diffusion between the gold and substrate metals. However, the coating interfaces have been found to be brittle and result in cracks when using this approach. The material cost of gold is also high, which increases manufacturing costs.

For bonding and soldering applications, it is desirable to develop a passivation layer that can suppress or inhibit oxidation over a prolonged period, such as in storage, but which can be selectively removed from a substrate when desired. It is desirable to be able to selectively remove passivation layers without the need to use additional processing steps, such as aggressive chemical etching or mechanical polishing. Therefore, new materials and methods are needed.

### BRIEF SUMMARY OF THE DISCLOSURE

A method is provided in a first embodiment. The method includes providing a substrate that includes a metal component on a surface (e.g., copper or aluminum). A polymeric layer is deposited on the surface using molecular layer deposition. The polymeric layer include a metalcone (e.g., a zincone, an alucone, or a zircone) and has a thickness from 1 nm to 20 nm. The polymeric layer is annealed such that a structural change occurs in the polymeric layer.

A surface treatment can be performed of the surface before depositing the polymeric layer. The surface treatment can reduce the surface. In an instance, the surface treatment uses a hydrogen plasma.

The depositing can includes more than one cycle. Each of the cycles forms 1 Å or more of the polymeric layer. In an instance, at least four of the cycles alternate between different species. For example, one of the cycles can use a polyol and another of the cycles can use diethylzine, trimethylaluminum, or tetrakisdimethylamidozirconium.

In another instance, the depositing includes injecting a purge gas between each of the cycles. The purge gas can be N₂ or Ar.

In another instance, each of the cycles forms from 1 Å to 3 Å of the polymeric layer.

The depositing can occur in a chamber. A pressure of the chamber can be from 0.001 Torr to 10 Torr during the depositing.

The thickness can be from 1 nm to 5 nm.

The method can further include depositing a dielectric layer between the surface and the polymeric layer.

The method can further include depositing a dielectric layer on a side of the polymeric layer opposite the surface.

The annealing can occur during soldering or bonding of the metal component.

The structural change can be removal of at least part of the polymeric layer, densification of the at least part of the polymeric layer, and/or a change in thickness of the polymeric layer.

In a second embodiment, a substrate with the polymeric layer is provided. The polymeric layer is deposited using the method of the first embodiment.

### DESCRIPTION OF THE DRAWINGS

For a fuller understanding of the nature and objects of the disclosure, reference should be made to the following detailed description taken in conjunction with the accompanying drawings, in which:
FIG. 1 is a diagram of an exemplary substrate in accordance with the present disclosure;
FIG. 2 is a diagram of another exemplary substrate in accordance with the present disclosure;
FIG. 3 is a flow chart of a method in accordance with the present disclosure; and
FIG. 4 is a system in accordance with the present disclosure.

### DETAILED DESCRIPTION OF THE DISCLOSURE

Although claimed subject matter will be described in terms of certain embodiments, other embodiments, including embodiments that do not provide all of the benefits and features set forth herein, are also within the scope of this disclosure. Various structural, logical, process step, and electronic changes may be made without departing from the scope of the disclosure. Accordingly, the scope of the disclosure is defined only by reference to the appended claims.

Embodiments disclosed herein use metalcone coatings prepared by molecular layer deposition (MLD). The coating is a polymer which includes, consists of, or consists essential of metal ions and organic linkers such as ethylene glycol. Substrates that include copper, iron, tin, silver, aluminum, or other metals can be pretreated with reducing plasma to remove the native oxide prior to coating deposition, which may help the coating performance.

Depending upon the application, the barrier layer can include an inert metal, dielectric, organic, or other type of coating. For a given film thickness, a dielectric coating is usually more effective as an oxidation barrier than other coatings because metal coatings are more prone to intermetallic diffusion and organic coatings tend to be more permeable. However, a dielectric layer with a thickness more than a few nanometers can adversely affect the subsequent processes. In a bonding or soldering process the oxidation barrier coating should be thin enough to allow for proper bonding/soldering, break, and/or structural changes to allow for the formation of metallic contacts. Embodiments described herein include a metal-organic polymeric coating used as an oxidation barrier. It has the ability to prevent metal oxidation, but can have a structural change (e.g., degradation) during the bonding or soldering process. The thickness of the polymeric coating can be from approximately 1 nm to 20 nm (e.g., from 2 nm to 5 nm or from 2 nm to 10 nm), but the desired thickness can depend on the application.

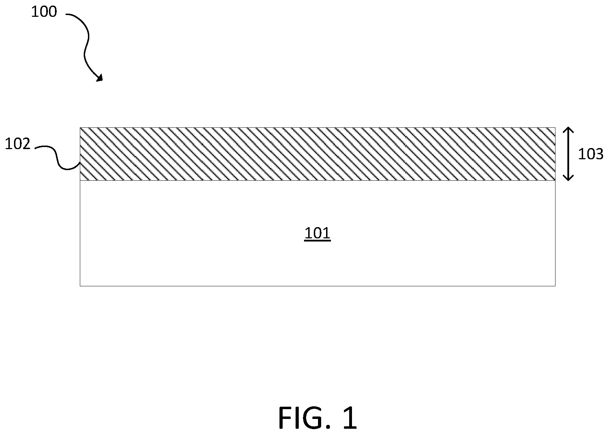

FIG. 1 is a block diagram of a substrate 100. The substrate 100 includes a metal component 101. The metal component 101 may be copper, iron, tin, silver, aluminum, or other metals. The metal component 101 can be an exposed surface on the substrate 100. The metal component 101 can be on a silicon wafer, printed circuit board, or other materials.

A polymeric layer 102 is disposed on the metal component 101. The polymeric layer 102 can have a thickness 103, which may be from 1 nm to 20 nm. The polymeric layer 102 is stable at room temperature, but structural changes can occur at high temperatures (e.g., from 200 °C to 300 °C temperatures used for soldering and bonding). The structural change of the polymeric layer 102 can be used for subsequent manufacturing processes, such as bonding or soldering. The polymeric layer 102 may not adversely affect bonding or soldering and can provide temporary protection of the metal component 101 prior to and during soldering or bonding. The polymeric layer 102 also may not affect device reliability or performance.

The polymeric layer 102 can be deposited on the surface of the substrate 100 using MLD. The MLD technique can be performed in a molecular vapor deposition (MVD) tool. The typical average thickness grown by MLD is approximately one molecular layer per deposition cycle.

The polymeric layer 102 can include, consist of, or consist essentially of one or more metalcones. The metalcone may be, for example, a zincone, an alucone, or a zircone. Metalcones are hybrid organic-inorganic films that can be deposited on a surface. The metalcones are typically based on metal precursors and various organic alcohols that yield metal alkoxide polymer films. In an instance, metalcones are made from sequential, self-limiting reactions of metal and organic alcohol precursors.

The polymeric layer 102 can serve as a barrier layer to prevent oxidation at room temperature so that sufficient shelf life of the substrate 100 can be attained. The polymeric layer 102 also can have a structural change occur at high temperatures, which facilitates the subsequent bonding or soldering process of the metal component 101.

The polymeric layer 102 can have a thickness 103 from 1 nm to 20 nm, including all ranges and values in between. For example, the thickness may be from 1 nm to 5 nm, 2 nm to 5 nm, 2 nm to 10 nm, or may be approximately 5 nm. This thickness is large enough to prevent oxidation on the metal component 101 during storage conditions, but thin enough to enable structural changes during later processing. Thinner polymeric layers 102 are possible, but polymeric layers 102 thinner than 1 nm may not provide enough passivation at low temperatures to prevent oxidation. Polymeric layers 102 thicker than 20 nm may adversely affect bonding.

A surface treatment of the surface of the substrate 100 and/or metal component 101 can be performed before depositing the polymeric layer 102. The surface treatment can reduce the surface. The surface treatment also can remove surface organic contaminants and native oxides. In an instance, the surface treatment uses a hydrogen plasma.

Depositing the polymeric layer 102 can include a plurality of cycles. Each cycle can form 1 Å or more of the polymeric layer 102. For example, each of the cycles can form from 1 Å to 3 Å of the polymeric layer 102. Reaction cycles can be repeated to achieve the desired thickness 103.

In an instance, a first cycle uses a first species and a second subsequent cycle can use a second species. Thus, the cycles can alternate between different species. For example, one of the cycles can use diethylzinc (DEZ) and another of the cycles can use ethylene glycol. The species in these cycles can be gaseous. The process can cycle between DEZ and ethylene glycol four or more times. A zincone material can be formed from DEZ and ethylene glycol. An alucone material can be trimethylaluminum (TMA) and ethylene glycol. A zircone material can be tetrakisdimethylamidozirconium (TDMAZ) and ethylene glycol. Thus, the cycle can alternate between, for example, DEZ and ethylene glycol, TMA and ethylene glycol, or TDMAZ and ethylene glycol.

While ethylene glycol is used in this example, other diols, triols, or polyols also can be used. For example, a triol (e.g., glycerol), other glycol (e.g., propylene glycol), or the like can be used.

A purge gas, such as N₂ or argon, can be injected between two of the cycles.

The deposition of the polymeric layer 102 can occur in a chamber. A pressure of the chamber can be from 0.001 Torr to 1 Torr during the deposition, such as from 0.01 Torr and 0.5 Torr or from 0.05 Torr and 0.5 Torr. The temperature in the chamber can depend on the species. For example, the MLD temperature window of zincone can be from approximately 120 °C to approximately 250 °C. In an instance, partial pressures of DEZ and ethylene glycol in the expansion volume during each precursor injection is approximately 1 Torr, which corresponds to a reaction chamber pressure of approximately 0.05 Torr during each half-cycle. An expansion volume pressure from 0.1 Torr to 10 Torr is typical.

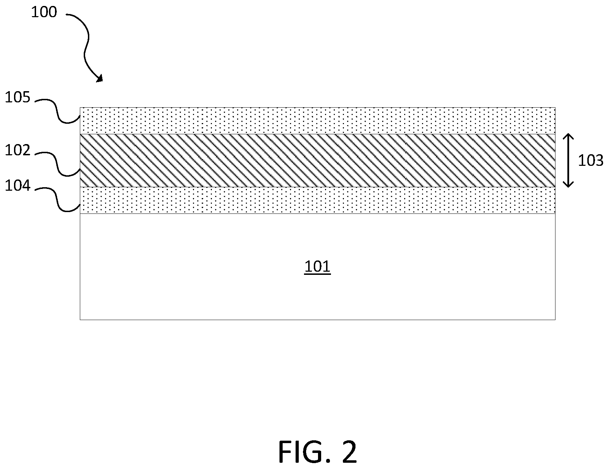

One or more optional dielectric layers can be deposited on the substrate 100, which is shown in FIG. 2. An optional dielectric layer 104 can be deposited between the metal component 101 and the polymeric layer 102. An optional dielectric layer 105 also can be deposited on a surface of the polymeric layer 102 opposite the metal component 101. A dielectric layer beneath or above the polymeric layer 102 can improve the barrier performance, but this dielectric layer may impair the bondability or solderability. The dielectric material may be one or more of alumina (Al₂O₃), GeO₂, ZnO, ZrO₂, SiOx, SiO₂, Si3N4, silicon oxynitride (SiOxNy), TiO₂, ZrO₂, HfO₂, SnO₂, In₂O₃, or Ta₂O₅, though other materials are possible. The thickness of a dielectric layer is usually ≤ 10 nm, which is thinner than a typical barrier layer that does not include a polymeric layer 102 and still allows adequate bonding/soldering.

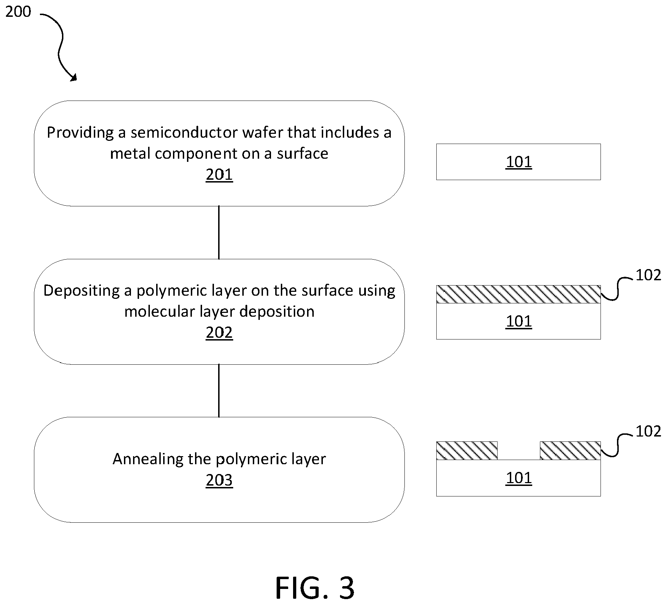

FIG. 3 is a flow chart of a method 200 with corresponding illustrations using the embodiment of FIG. 1. A semiconductor wafer with a metal component on a surface is provided at 201. The polymeric layer, such as polymeric layer 102, is deposited on the surface using MLD at 202. In an embodiment, the substrate is pre-treated with a reducing plasma such as hydrogen, which removes the surface organic contaminants and native oxide. The polymeric coating is then grown in a cycle-by-cycle mode using an MLD technique in an MVD tool.

The polymeric layer is annealed at 203. This annealing causes a structural change to the polymeric layer. For example, the annealing can cause one or more of densification, degradation, material removal, other thickness changes, or other mechanisms. In an instance, at least part of the polymeric layer or all of the polymeric layer can be densified. In another instance, at least part of the polymeric layer or all of the polymeric layer can be removed. In yet another instance, at least part of the polymeric layer or all of the polymeric layer can be degraded. In yet another instance, at least part of the polymeric layer or all of the polymeric layer can be subject to a thickness change (e.g., thinning). If only part of the polymeric layer has a structural change occur, this may be the location of the soldering or bonding.

In an instance, the annealing causes a structural change to enough of the polymeric layer to allow soldering. The soldering or bonding can occur at a temperature from 200 °C to 300 °C. For example, a temperature from 200 °C to 260 °C may be used. These temperatures can cause the structural change to the polymeric layer.

The annealing at 203 can be part of a soldering or bonding step. The metal component can be soldered or bonded as part of the annealing or subsequent to the annealing.

A thin metalcone layer with a thickness ranging from approximately 1 nm to 20 nm can be used for temporary barrier applications such as bonding and soldering. Table 1 shows test results for oxidation prevention and solderability tests for copper samples.

**Table 1**

| Samples | Oxide Growth at Room Temperature | Oxide Growth at 100 °C | Solderability test at 250 °C |
|---|---|---|---|
| Bare Cu | Yes | Yes | Not Pass |
| Cu with metal cone coating | No | Yes | Pass |
| Cu with dielectric coating | No | No | Not Pass |

For over a six-month period at room temperature, ellipsometry data show that the Cu sample with a metalcone coating in accordance with the present disclosure has negligible oxidation. In contrast, the bare Cu sample has a native oxide layer grown with a thickness from 1 to 10 nm. After annealing for 1 hour at 100 °C in air, the Cu sample coated with metalcone shows oxidation, but the oxide thickness is much lower than the bare Cu sample. The Cu sample coated by dielectric materials shows no oxidation both at room and high temperature. The solderability test was performed by measuring the wettability of Sn containing solder with and without flux in a reflow oven. Only the Cu sample coated with metalcone can allow the solder to be wetted. Thus, embodiments disclosed herein can be used to passivate Cu after pad formation to protect it during storage prior to bonding. Metal alkoxide polymer films are not thermally stable and can break down at elevated temperatures.

For the test results shown in Table 1, the listed samples were kept at either room temperature for one month or 100 °C for two hours. Oxide growth was then measured by ellipsometry. "No" means no oxidation was measured and "yes" means oxidation was detected within the measurement limits of the ellipsometry. For solderability, "pass" means the solder visibly wets/spreads and "not pass" means the solder does not visibly wet/spread. The metalcone coating was a 5 nm thick zincone layer.

Soldering or bonding applications typically do not need moisture barriers with a permeation as low as those for gas permeation barrier applications. For temporary protection until, during, or through subsequent soldering or bonding, a metalcone can provide a sufficient moisture barrier.

Pre-anneal and post-anneal film thickness measurements of two metalcone materials are shown below in Table 2. The metalcone materials were heated at 100 °C and 250 °C.

| | 100 °C at 2 hours | | 250 °C at 10 seconds | |
|---|---|---|---|---|
| | Pre-anneal (nm) | Post-anneal (nm) | Pre-anneal (nm) | Post-anneal (nm) |
| Alucone | 14.2 | 11.8 | 13.2 | 1.5 |
| Zincone | 5.6 | 3.8 | 17.7 | 0.2 |

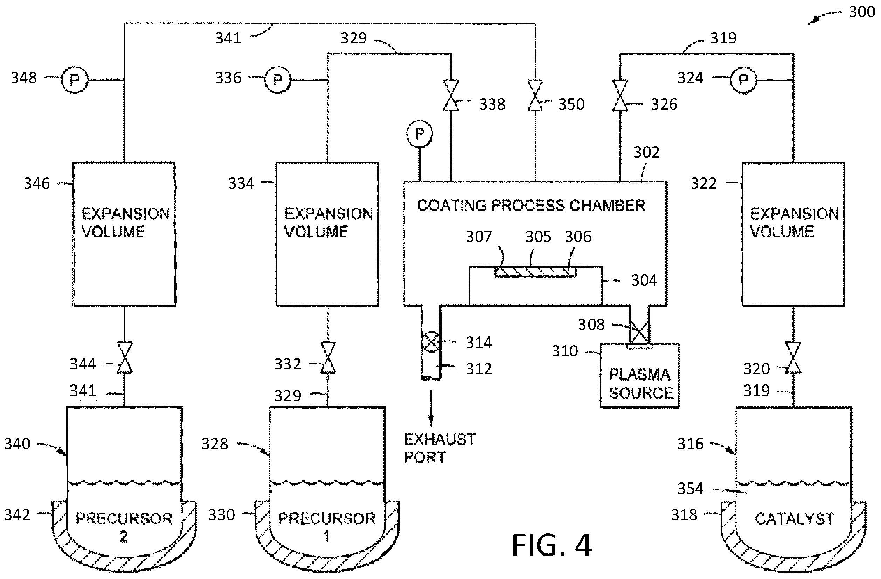

FIG. 4 shows a cross-sectional schematic of an MVD system 300 for vapor deposition of thin coatings. The MVD system 300 includes a process chamber 302 in which thin (typically 1 Å to 200 Å coatings or thicker coatings in the range of about 200 Å (20 nm) to about 1 micron thick (1,000 nm) may be vapor deposited. A substrate 306, such as the substrate 100, to be coated rests upon a substrate holder 304, typically within a recess 307 in the substrate holder 304, or directly on the bottom of the process chamber 302.

Depending on the chamber design, the substrate 306 may rest on the chamber bottom (not shown in this position in FIG. 4). Attached to process chamber 302 is a remote plasma source 310, connected via a valve 308. Remote plasma source 310 may be used to provide a plasma which is used to clean and/or convert a substrate surface to a particular chemical state prior to application of a coating (which enables reaction of coating species and/or catalyst with the surface, thus improving adhesion and/or formation of the coating); or may be used to provide species helpful during formation of the coating or modifications of the coating after deposition. The plasma may be generated using a microwave, DC, inductive RF power source, or combinations thereof. The process chamber 302 makes use of an exhaust port 312 for the removal of reaction byproducts and is opened for pumping/purging the chamber 302. A shut-off valve or a control valve 314 is used to isolate the chamber or to control the amount of vacuum applied to the exhaust port. The vacuum source is not shown in FIG. 4.

The MVD system 300 shown in FIG. 4 is illustrative of a vapor deposited coating which employs two precursor materials and a catalyst. One skilled in the art will understand that one or more precursors and from zero to multiple catalysts may be used during vapor deposition of a coating. A catalyst storage container 316 contains catalyst 354, which may be heated using heater 318 to provide a vapor, as necessary. The precursor and catalyst storage container walls and transfer lines into process chamber 302 can be heated to maintain a precursor or catalyst in a vaporous state, minimizing or avoiding condensation. The same is true with respect to heating of the interior surfaces of process chamber 302 and the surface of substrate 306 to which the coating (not shown) is applied. A control valve 320 is present on transfer line 319 between catalyst storage container 316 and catalyst vapor reservoir 322, where the catalyst vapor is permitted to accumulate until a nominal, specified pressure is measured at pressure indicator 324. Control valve 320 is in a normally-closed position and returns to that position once the specified pressure is reached in catalyst vapor reservoir 322. At the time the catalyst vapor in vapor reservoir 322 is to be released, valve 326 on transfer line 319 is opened to permit entrance of the catalyst present in vapor reservoir 322 into process chamber 302 which is at a lower pressure. Control valves 320 and 326 are controlled by a programmable process control system of the kind known in the art (which is not shown in FIG. 4).

A Precursor 1 storage container 328 contains coating reactant Precursor 1, which may be heated using heater 330 to provide a vapor, as necessary. Precursor 1 transfer line 329 and vapor reservoir 334 internal surfaces can be heated to maintain a Precursor 1 in a vaporous state, minimizing and preferably avoiding condensation. A control valve 332 is present on transfer line 329 between Precursor 1 storage container 328 and Precursor 1 vapor reservoir 334, where the Precursor 1 vapor is permitted to accumulate until a nominal, specified pressure is measured at pressure indicator 336. Control valve 332 is in a normally closed position and returns to that position once the specified pressure is reached in Precursor 1 vapor reservoir 334. At the time the Precursor 1 vapor in vapor reservoir 334 is to be released, valve 338 on transfer line 329 is opened to permit entrance of the Precursor 1 vapor present in vapor reservoir 334 into process chamber 302, which is at a lower pressure. Control valves 332 and 338 are controlled by a programmable process control system of the kind known in the art (which is not shown in FIG. 4).

A Precursor 2 storage container 340 contains coating reactant Precursor 2, which may be heated using heater 342 to provide a vapor, as necessary. Precursor 2 transfer line 341 and vapor reservoir 346 internal surfaces can be heated to maintain Precursor 2 in a vaporous state, minimizing, and preferably avoiding condensation. A control valve 344 is present on transfer line 341 between Precursor 2 storage container 346 and Precursor 2 vapor reservoir 346, where the Precursor 2 vapor is permitted to accumulate until a nominal, specified pressure is measured at pressure indicator 348. Control valve 341 is in a normally-closed position and returns to that position once the specified pressure is reached in Precursor 2 vapor reservoir 346. At the time the Precursor 2 vapor in vapor reservoir 346 is to be released, valve 350 on transfer line 341 is opened to permit entrance of the Precursor 2 vapor present in vapor reservoir 346 into process chamber 302, which is at a lower pressure. Control valves 344 and 150 are controlled by a programmable process control system of the kind known in the art (which is not shown in FIG. 4).

During formation of a coating (not shown) on a surface 305 of substrate 306, at least one incremental addition of vapor equal to the vapor reservoir 322 of the catalyst 354, and the vapor reservoir 334 of the Precursor 1, or the vapor reservoir 346 of Precursor 2 may be added to process chamber 302. The total amount of vapor added is controlled by both the adjustable volume size of each of the expansion chambers (typically 50 cc up to 1,000 cc) and the number of vapor injections (doses) into the reaction chamber. Further, the set pressure 324 for catalyst vapor reservoir 322, or the set pressure 336 for Precursor 1 vapor reservoir 334, or the set pressure 348 for Precursor 2 vapor reservoir 346, may be adjusted to control the amount (partial vapor pressure) of the catalyst or reactant added to any particular step during the coating formation process. This ability to control precise amounts of catalyst and vaporous precursors to be dosed (charged) to the process chamber 302 at a specified time provides not only accurate dosing of reactants and catalysts, but repeatability in the vapor charging sequence.

This apparatus provides a relatively inexpensive, yet accurate method of adding vapor phase precursor reactants and catalyst to the coating formation process, despite the fact that many of the precursors and catalysts are typically relatively non-volatile materials. In the past, flow controllers were used to control the addition of various reactants; however, these flow controllers may not be able to handle some of the precursors used for vapor deposition of coatings due to the low vapor pressure and chemical nature of the precursor materials. The rate at which vapor is generated from some of the precursors is generally too slow to function with a flow controller in a manner which provides availability of material in a timely manner for the vapor deposition process.

The apparatus discussed above allows for accumulation of the specific quantity of vapor in the vapor reservoir which can be charged (dosed) to the reaction. In the event it is desired to make several doses during the coating process, the apparatus can be programmed to do so, as described above. Additionally, adding of the reactant vapors into the reaction chamber in controlled aliquots (as opposed to continuous flow) reduces the amount of the reactants used and the cost of the coating.

One skilled in the art of chemical processing of a number of substrates simultaneously will recognize that a processing system which permits heat and mass transfer uniformly over a number of substrate surfaces simultaneously may be used to carry out the present invention.

Although the present disclosure has been described with respect to one or more particular embodiments, it will be understood that other embodiments of the present disclosure may be made without departing from the scope of the present disclosure. Hence, the present disclosure is deemed limited only by the appended claims and the reasonable interpretation thereof.

## Claims

1. A method comprising:
providing a substrate that includes a metal component on a surface;
depositing a polymeric layer on the surface using molecular layer deposition, wherein the polymeric layer includes a metalcone, and wherein the polymeric layer has a thickness from 1 nm to 20 nm; and
annealing the polymeric layer such that a structural change occurs in the polymeric layer.

2. The method of claim 1, further comprising performing a surface treatment of the surface before depositing the polymeric layer, wherein the surface treatment reduces the surface, optionally wherein the surface treatment uses a hydrogen plasma.

3. The method of claim 1, wherein the depositing includes a plurality of cycles, and wherein each of the cycles forms 1 Å or more of the polymeric layer.

4. The method of claim 3, wherein at least four of the cycles alternate between different species, optionally wherein one of the cycles uses a diol, triol, or polyol and another of the cycles uses diethylzine, trimethylaluminum, or tetrakisdimethylamidozirconium.

5. The method of claim 3, wherein the depositing includes injecting a purge gas between each of the cycles, optionally wherein the purge gas is N₂ or Ar.

6. The method of claim 3, wherein each of the cycles forms from 1 Å to 3 Å of the polymeric layer.

7. The method of claim 1, wherein the depositing occurs in a chamber, and wherein a pressure of the chamber is from 0.001 Torr to 10 Torr during the depositing.

8. The method of claim 1, wherein the thickness is from 1 nm to 5 nm.

9. The method of claim 1, wherein the metalcone is a zincone, an alucone, or a zircone.

10. The method of claim 1, further comprising depositing a dielectric layer between the surface and the polymeric layer.

11. The method of claim 1, further comprising depositing a dielectric layer on a side of the polymeric layer opposite the surface.

12. The method of claim 1, wherein the metal component is copper or aluminum.

13. The method of claim 1, wherein the annealing occurs during soldering or bonding of the metal component.

14. The method of claim 1, wherein the structural change is: i) removal of at least part of the polymeric layer; and/or ii) densification of the at least part of the polymeric layer; and/or iii) a change in thickness of the polymeric layer.

15. A substrate with the polymeric layer deposited using the method of claim 1.
